# EUROPEAN PATENT SPECIFICATION

(11) **EP 0 421 015 B1**
(45) Date of publication and mention of the grant of the patent: **18.01.1995**
(21) Application number: 89118603.3
(22) Date of filing: 06.10.1989
(51) Int. Cl.: C23C 14/08, C23C 14/35, C23C 14/54, H01J 37/34

(54) **Process for producing transparent conductive film**
Verfahren zur Herstellung eines leitenden, durchsichtigen Films
Procédé produire un film transparent conducteur

(43) Date of publication of application: 10.04.1991
(73) Proprietor: NIHON SHINKU GIJUTSU KABUSHIKI KAISHA, Chigasaki-shi Kanagawa-ken (JP)
(72) Inventor: Nakamura, Kyuzo c/o Nihon Shinku Gijutsu K.K., Chigasaki-shi Kanagawa-ken (JP); Ishibashi, Satoru c/o Nihon Shinku Gijutsu K.K., Chigasaki-shi Kanagawa-ken (JP); Ota, Yoshifumi c/o Nihon Shinku Gijutsu K.K., Chigasaki-shi Kanagawa-ken (JP); Higuchi, Yasushi c/o Nihon Shinku Gijutsu K.K., Chigasaki-shi Kanagawa-ken (JP)
(74) Representative: Melzer, Wolfgang, Dipl.-Ing.

(56) References cited:
- EP-A- 0 115 629
- US-A- 4 500 408
- PATENT ABSTRACTS OF JAPAN, vol. 9, no. 112 (C-281)[1835], 16th May 1985; & JP-A-60 5878

## Description

The invention relates to a process for producing an In-O or In-Sn-O based transparent conductive film on a substrate comprising sputtering a target by applying a sputtering voltage to the target while introducing a sputtering gas to generate a plasma discharge between the substrate and the target and applying a magnetic field to the surface of the target.

Such conductive film (hereinafter referred to as an ITO-film) is used for a display element for a liquid crystal display or the like.

There are conventionally known processes for producing such a transparent conductive film such as coating, vacuum deposition, and gas-phase reaction processes, as well as sputtering processes, including a DC or RF double-pole sputtering and a DC or RF magnetron sputtering. Among these producing processes, the sputtering processes are often used because they enable a transparent conductive film to be formed uniformly onto a large-sized substrate.

US-A- 4 500 408 discloses an apparatus for sputter coating including means for controlling the coating process and a method therefor. In particular a magnetron cathode supporting the sputter target is provided with an electromagnet located at the rear side of the target plate. The electromagnet is driven by a coil power (DC) source. In order to obtain a sputter plasma, a plasma power (DC) source is connected to the sputter cathode and to the vacuum chamber (earth). Further, in order to achieve a constant plasma impedance, the magnetic field strength is controlled via a controller acting on the coil power source with reference to the measured plasma voltage such as to maintain plasma (i. e. equal to sputter) voltage and current constant.
The current applied to the coils producing the magnetic field for the target is controlled by a CPU in response to several parameters. This known apparatus does not concern the producing of In-O of In-Sn-O based transparent conductive films at all and consequently the targets used in this apparatus do not comprise In-Sn.

It is known that the temperature of a substrate and the partial pressure of oxygen are factors affecting the electrical resistivity of a transparent conductive film produced by the sputtering process. Concerning the temperature of a substrate, it has been understood that the higher the substrate temperature, the lower the electrical resistivity of the resulting film. On the other hand, for the partial pressure of oxygen, it has been understood that in a region of lower oxygen partial pressure, the density of a carrier is larger, and the mobility is smaller because there are many vacancies of oxygen in such a region. Whereas in a region of higher oxygen partial pressure, the density of a carrier is smaller, and the mobility is larger. Thus, there is an optimum partial pressure of oxygen that will result in an electrical resistivity of a minimum value from an even balance of the density and the mobility. Thus, it was a practice in the prior art sputtering process to form a transparent conductive film having a lower electrical resistivity wherein parameters of the substrate temperature and the partial pressure of oxygen gas were controlled.

In the prior art sputtering process, the reduction in the electrical resistivity of transparent conductive film was limited when it was impossible to increase the temperature of a substrate. An example is the case of a full color STN system, wherein an ITO film is formed on a substrate of a color filter material having a heat-resistant temperature as low as 160 to 200 °C.

Additionally, the prior art process also has the problem of non-consistent electrical resistivity. This occurs when the sputtering is continuously carried out, resulting in an insulating oxide of In-O being produced on a surface of a target, thus discoloring the surface to black (such a discoloration will be referred to as blackening). With an increase of the blackening of the target, the electrical resistivity of a transparent conductive film formed on the substrate may be increased. Therefore, when a transparent conductive film is continously formed on each of a plurality of substrates, for a long period of time, the electrical resistivity of the resulting film may be gradually increased. Thus, it was impossible to provide a transparent conductive film having a consistent electrical resistivity.

Thus, it is an object of the present invention to provide a process whereby a transparent conductive film of low and relative uniform electrical resistivity can be continuously produced.

According to the present invention the process is characterized in that
- the target 8 comprises In, or In and Sn,
- the sputtering gas comprises at least oxygen and
- the intensity of the magnetic field is increased as the conductive film is being formed during the sputter process in such a manner to maintain a timely constant sputter voltage at 340 V or less.

The invention is based on zealous studies of the inventors to accomplish the above object. They have found that in addition to the substrate temperature and the partial pressure of oxygen as the factors affecting the electrical resistivity of a transparent conductive film formed on a substrate, the sputtering voltage greatly affects the electrical resistivity of a resulting transparent conductive film and that if the sputtering is continuously carried out for a long period of time, the sputtering voltage may be gradually increased, but the sputtering voltage can be reduced by increasing the intensity of a magnetic field on a surface of a target, and the sputtering voltage can be easily kept constant by adjusting the intensity of the magnetic field.

According to the present invention, targets for a transparent conductive film formed on a substrate include In, an In-Sn alloy, a sinter of In oxide, a sinter of In-Sn oxide, etc. Among them, the sinter of In-Sn oxide is preferred because its use in the formation of a transparent film onto a substrate results in the film remaining in a stable state for a long period of time. Further, the intensity of a magnetic field on a surface of a target is adjusted in a range of 0.317·10⁵ A/m (400 Oe) or more so that the sputtering voltage during sputtering film formation operation is kept constant.

Sputtering gases include, for example, a mixed gas comprising an inert gas, such as argon gas, and an oxygen gas added thereto. When argon gas is used as an inert gas, the pressure of the mixed gas may be generally of the order of 0,133 Pa (10⁻³ Torr), and the partial pressure of the oxygen gas may be generally of the order of 1.33·10⁻³ Pa (10⁻⁵ Torr).

In the subsequence for forming an In-O or In-Sn-O based transparent conductive film by a sputtering process, an anion such as O-, O²⁻ or InO⁻, is generated in the vicinity of the surface of a target. If the target voltage is, for example, -400V, these anions may be accelerated by an energy of 400 eV to smash into a substrate, thereby providing micro-damages to a transparent conductive film which is being formed. When a divalent ion such as In²⁺ and Sn²⁺ is generated by the micro-damages, which acts as an acceptor, the density of a carrier may be reduced. When the oxygen vacancies are collapsed the density of a carrier may be also reduces. The reduction in density of a carrier will cause an increase in the electrical resistivity.

According to the present invention, sputtering is carried out at the intensity of a magnetic field of 0.317·10⁵ A/m (400 Oe) or more on a surface of a target, whereby the sputtering voltage (equal to the target voltage) is lowered to suppress to a lower level the energy of an anion smashing into the substrate, thereby reducing the damage to a resulting transparent conductive film.

In addition, if sputtering is continuously conducted for a long period of time, the surface of a target may be blackened, attendant with an increase in sputtering voltage. On the other hand, it the intensity of the magnetic field on the target surface is increased during the sputtering operation, the density of plasma is increased and as a result, the sputtering voltage is reduced. Thus, the sputtering voltage may be kept constant by adjusting the intensity of the magnetic field during sputtering film formation operation.

The present invention will now be described by way of an embodiment with reference to the accompanying drawings.
Fig. 1 is a sectional view of one embodiment of a producing apparatus for carrying out a process for producing a transparent conductive film according to the present invention;
Fig. 2 is a characteristic graph illustrating the relationship between the sputtering voltage and the electrical resistivity under conditions of individual temperatures of a substrate;
Fig. 3 is a characteristic graph illustrating the relationship between the magnetic field intensity of magnetron and the sputtering voltage.
Fig. 4 is a characteristic graph illustrating the relationship between the sputtering time and the electrical resistivity when a sputtering has been continuously carried out for a long period of time with the intensity of magnetic field being adjusted to keep the sputtering voltage constant; and
Fig. 5 is a characteristic graph illustrating the relationship between the sputtering time and the electrical resistivity when a sputtering has been continuously carried out for a long period of time with the magnetic field intensity being kept constant.

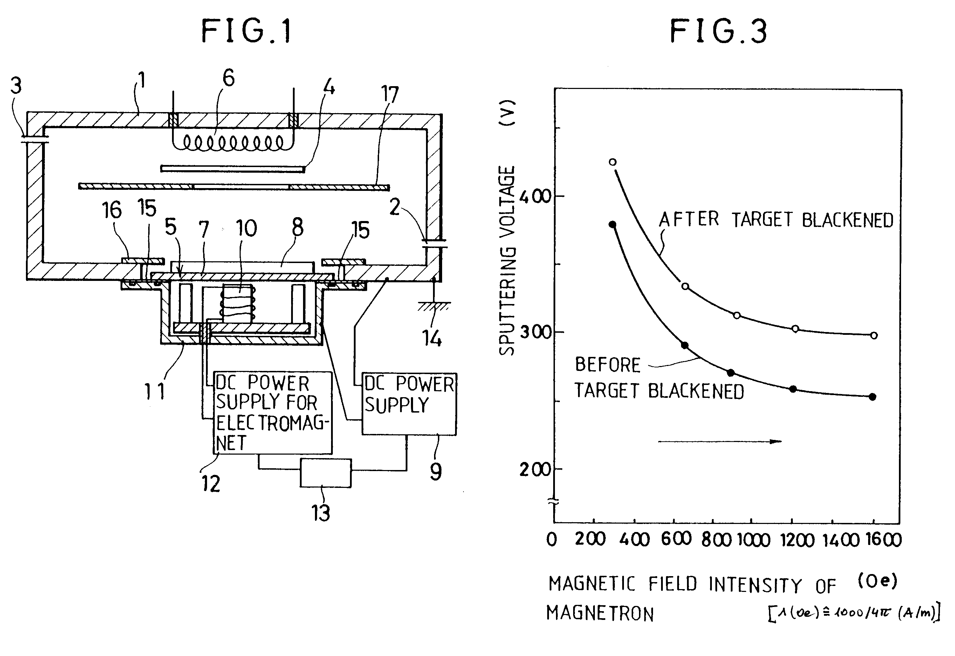

Fig. 1 illustrates one embodiment of an apparatus for producing a transparent conductive film. In Fig. 1, reference numeral 1 denotes a vacuum chamber that is designed so that the vacuum degree of the interior thereof is adjustable through an exhaust port 2, connected to suitable evacuating means such as an external vacuum pump, and so that a sputter gas, for example, one consisting of a mixed gas of argon and oxygen can be introduced into the vacuum chamber 1 through a gas inlet pipe 3 communicating with the vacuum chamber 1. In the vacuum chamber 1, a substrate 4 and a sputter cathode 5 are disposed in an opposed relation, and a heater 6 is mounted behind the substrate 4 for heating the latter.

A target 8, bonded by a brazing material, is disposed on a front surface of a backing plate 7 of the sputter cathode 5, and a cathode case 11, hausing therein an electromagnet 10 connected to a plasma discharging DC power supply 9 having a voltmeter, is disposed behind the backing plate 7 of the sputter cathode 5. The vacuum chamber 1 and the cathode case 11 are connected through the plasma discharging DC power supply 9, so that with the vacuum chamber 1 being at an earth potential, a negative voltage can be applied to the cathode case 11 to effect a DC magnetron sputtering within the vacuum chamber 1. In the illustrated embodiment, a controller 13 is connected to the plasma discharging DC power supply 9 and a DC power supply 12 for the electromagnet. The controller 13 is capable of receiving variation signals corresponding to variations in sputtering voltage supplied from the plasma discharging DC power supply 9, and controlling a current to the DC power supply 12 for the electromagnet in accordance with the variation signal. This adjusts the magnetic field intensity generated on a surface of the the target 8 within the range of 0.198·10⁵ to 1.270·10⁵ A/m (250 Oe to 1,600 Oe).

In Fig. 1, the reference numeral 14 is an earth connected to the vacuum chamber 1; the numeral 15 is an insulating sheet made of a Teflon plate disposed between the vacuum chamber 1 and the cathode case 11; the numeral 16 is an earth shield; and the numeral 17 is an anti-deposition plate.

It should be noted that while not shown, the target 8 is cooled by water cooling means mounted within the cathode case 11.

The following experiment was carried out with using the producing apparatus described above in order to examine the relationship between the sputtering voltage and the electrical resistivity of the resulting transparent conductive film.

Mounted within the vacuum chamber 1 in the producing apparatus described above, were a substrate 4 made of a light transmittable glass (No.7059 made by Corning Co. Corp., and having a size of 210 mm x 210 mm), and an oxide target 8 comprising In₂O₃ containing 10% by weight of SnO₂ incorporated therein (having a size of 125 mm x 406 mm). Then, the vacuum chamber 1 was evacuated by the evacuating means, through the exhaust port 2, to a degree of 1.064·10⁻³ Pa (8 x 10⁻⁶ Torr), and then, a sputtering gas consisting of argon and oxygen gases was introduced into the vacuum chamber 1 through the gas inlet pipe 3, so that the pressure of the interior of the vacuum chamber 1 was at 6.65·10⁻¹ Pa (5 x 10⁻³ Torr).

Then, the temperature of the substrate 4 was set at room temperature (25^{o}C), 160^{o}C end 460^{o}C, respectively, by heating the substrate 4 with a heater 6, respectively, and a sputtering was carried out at each of such temperatures while the current supplied from the DC power supply 12 to the electromagnet 10 was controlled by the controller 13 to adjust the intensity of the magnetic field generated on the surface of the target 8 and the sputtering voltage was varied in accordance with the adjustment of the magnetic field intensity, thus forming an In-Sn-O based transparent conductive film having a thickness of 100 nm (1,000 Å) on the substrate 4. In this case, the partial pressure of the oxygen gas was so adjusted so as to optimize to the conditions of the substrate temperatures and the sputtering voltages. In addition, the distance between the substrate 4 and the target 8 was 80 mm.

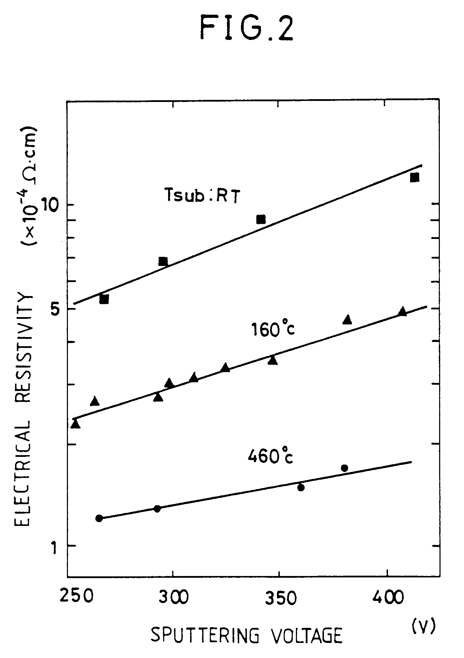

The electrical resistivity of the transparent conductive film formed by the above process was measured for every sputtering voltage at every substrate temperature, and the obtained results of measurement are shown in Fig. 2.

As apparent from Fig. 2, it was confirmed that the electrical resistivity of the transparent conductive film could be reduced as the sputtering voltage was reduced at all the substrate temperatures.

The following experiment was carried out with using the producing apparatus described above in order to examine the relationship between the intensity of magnetic field and the sputtering voltage.

Mounted within the vacuum chamber 1 in the producing apparatus described above, was a substrate 4 made or a light transmittable glass (No.7059 made by Corning Co. Corp., and having a size of 210 mm x 210 mm), and an oxide target 8 comprising In₂O₃ containing 10% by weight of SnO₂ incorporated therein (having a size of 125 mm x 406 mm). Then, the vacuum chamber 1 was evacuated by the evacuating means, through the exhaust port 2, to a degree of 1.064·10⁻³ Pa (8 x 10⁻⁶ Torr), and thereafter, a sputtering gas consisting of argon and oxygen gases was introduced into the vacuum chamber 1 through the gas inlet pipe 3, so that the pressure or the interior of the vacuum chamber 1 was 6.65·10⁻¹ Pa (5 x 10⁻³ Torr). In this case, the partial pressure of the oxygen gas was 5.32·10⁻³ Pa (4 x 10⁻⁵ Torr). In addition, the distance between the substrate 4 and the target 8 was 80 mm.

Then, the DC magnetron sputtering was carried out, while the current supplied form the DC power supply 12 to the electromagnet 10 was controlled by the controller 13, to vary the intensity of the magnetic field at a central side between magnetic poles generated on the surface of the target 8, i.e., the magnetic field intensity of the magnetron field from 0.198·10⁵ to 1.270·10⁵ A/m (250 Oe to 1,600 Oe). Further, the sputtering voltages were respectively determined at the following two stages of the sputtering: an initial stage of the sputtering (when the surface of the target material was not yet blackened, i.e., before the target blackened); and a stage after 40 hours of sputtering had lapsed (when the surface of the target material had been blackened, i.e., after the target blackened).

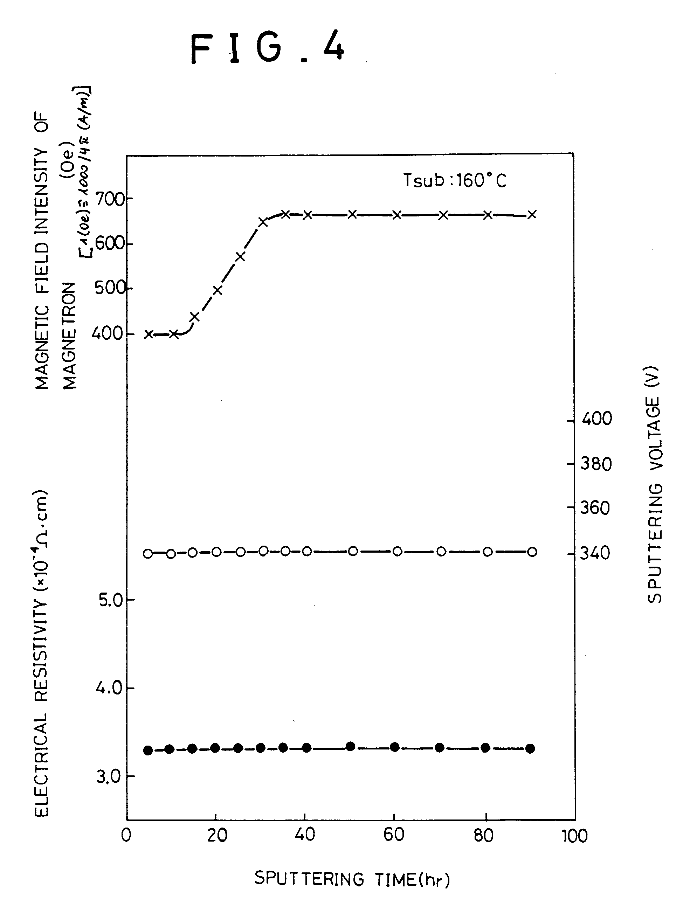

In each of stages, the sputtering voltage was measured for every magnetic field intensity (magnetic field intensity of magnetron), and the obtained results of measurement are shown in Fig. 3.

As apparent from Fig. 3, it was confirmed that in any of the initial sputtering stage and the stage after 40 hours of sputtering had lapsed, the sputtering voltage was reduced as the magnetic field intensity was increased and hence, it is possible to maintain the constant sputtering voltage by varying the intensity of the magnetic field on the surface of the target (in the direction of the arrow as shown in Fig. 3).

A specified embodying example of a process for forming a transparent conductive film as well as comparative Example will be described below.

Mounted within the vacuum chamber 1, in the producing apparatus described above, was a substrate 4 made of a light transmittable glass (No. 7059 made by Corning Co. Corp., and having a size of 210 mm x 210 mm and a thickness of 1.1 mm, and an oxide target 8 comprising In₂O₃ containing 10% by weight of SnO₂ incorporated therein (having a size of 125 mm x 406 mm). Then, the vacuum chamber 1 was evacuated by the evacuating means through the exhaust port 2, to a degree of 1.064·10⁻³ Pa (8 x 10⁻⁶ Torr), and thereafter, a sputtering gas consisting of argon and oxygen gases was introduced into the vacuum chamber 1 through the gas inlet pipe 3 so that the pressure of the interior of the vacuum chamber 1 was 6.65·10⁻¹ Pa (5 x 10⁻³ Torr). In this case, the partial pressure of the oxygen gas was 5.32·10⁻³ Pa (4 x 10⁻⁵ Torr), and the distance between the substrate 4 and the target 8 was 80 mm.

Then, the temperature of the substrate 4 was set at 160^{o}C by the heater 6, and with a current from the DC power supply 12 to the electromagnet 10 being varied by the controller 13, a sputtering was continuously carried out for a long period of time while adjusting the intensity of a magnetic field generated on the surface of the target 8 to maintain the sputtering voltage constant (at 340V in this example), resulting in the formation of an In-Sn-O based transparent conductive film having a thickness of 100 nm (1,000 Å) on each of a plurality of substrates 4.

The electrical resistivity of each of the transparent conductive films formed by the above process was measured for every individual sputtering time, and the sputtering voltage and the magnetic field intensity (the magnetic field intensity of magnetron) were measured for every individual sputtering time. The obtained resultes of measurement are shown in Fig. 4.

A sputtering was carried out continuously for a long period of time in the same manner as in the above example to form an In-Sn-O based transparent conductive film having a thickness of 100 nm (1,000 Å) on each of a plurality of substrates 4, except that the intensity of a magnetic field generated on the surface of a target 8 was maintained at 0.317·10⁵ A/m (400 Oe) without adjustment thereof.

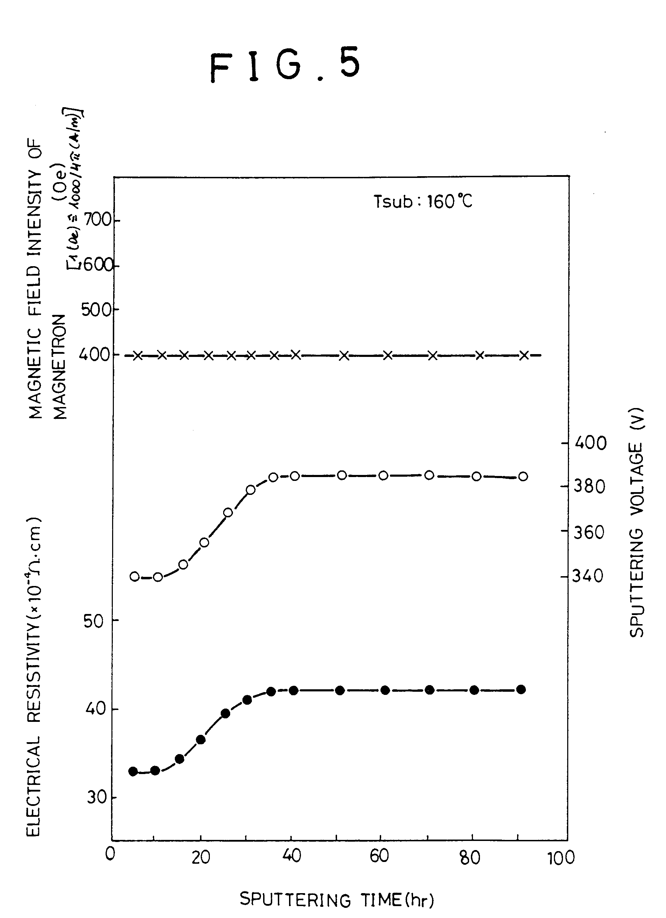

The electrical resistivity of each of the transparent conductive films formed by the above process was measured for every individual sputtering time, and the sputtering voltage and the magnetic field intensity (the magnetic field intensity of magnetron)were measured for every individual sputtering time. The obtained resultes of measurement are shown in Fig. 5.

As apparent from Fig. 4, by the producing process of the present invention in which the magnetic field intensity was adjusted to maintain the sputtering voltage at a constant value, a transparent conductive film having a consistent electrical resistivity were obtained. To the contrary, as apparent from Fig. 5, in the process in the Comparative Example in which the adjustment of the magnetic field intensity was not made, the surface of the target material was blackened and the sputtering voltage wad raised from a point after the lapse of about 10 to 30 hours from the start of the sputtering. This was attended with an increase in electrical resistivity of the transparent conductive films.

Therefore, it was confirmed that according to the producing process of the present invention, it is possible to continuously form transparent conductive films having a consistent electrical resistivity on the substrates from immediately after the start of the sputtering to the completion of the sputtering (repacement by a new target).

As discussed above, in the process for producing a transparent conductive film according to the present invention, a sputtering is carried out in such a condition that the intensity of a magnetic field on a surface of a target is adjusted in a range of 0.317·10⁵ A/m (400 Oe) or more so that the sputtering voltage, during sputtering film formation operation, is kept constant. Therefore, when a target is sputtered by a sputtering process to form a transparent conductive film on a substrate, the sputtering voltage can be maintained at a comparatively lower constant value during formation of the film by adjusting the intensity or the magnetic field, even if the sputtering is continuously carried out for a long period of time. This leads to the effect that it is possible to produce transpatent conductive films having a lower and consistently uniform electrical resistivity, and that it is possible to form a transparent conductive film having a lower electrical resistivity even if a substrate is of a material having a lower heat-resistant temperature.

In an apparatus for producing a transparent conductive film according to the process of the present invention, the electromagnet for adjusting the intensity of a magnetic field on the surface of the target is mounted on the rear surface side of the target, and the controller for controlling the current to the electromagnet in accordance with a change in sputtering voltage is connected to a DC power supply for said electromagnet. Therefore, it is possible to adjust the intensity of magnetic field on the surface of a target by the electromagnet to maintain a lower sputtering voltage constant, thus leading to the effect that a transparent conductive film having a lower and consistently uniform electrical resistivity can be easily produced.

## Claims

1. A process for producing an In-O or In-Sn-O based transparent conductive film on a substrate (4) comprising
- sputtering a target (8) by applying a sputtering voltage to the target while introducing a sputtering gas to generate a plasma discharge between the substrate (4) and the target (8)
- applying a magnetic field to the surface of the target (8)
**characterized in that**
- the target (8) comprises In, or In and Sn,
- the sputtering gas comprises at least oxygen and
- the intensity of the magnetic field is increased as the conductive film is being formed during the sputter process in such a manner to maintain a timely constant sputter voltage at 340 V or less.

## Patentansprüche

1. Verfahren zur Erzeugung einer transparenten leitfähigen Schicht auf In-O- oder In-Sn-O-Basis auf einem Substrat (4), wobei das Verfahren umfaßt:
das Zerstäuben eines Targets (8) durch Anlegen einer Zerstäubungsspannung an das Target (8), während ein Zerstäubungsgas eingeführt wird, um eine Plasmaentladung zwischen dem Substrat (4) und dem Target (8) zu erzeugen,
das Anlegen eines Magnetfelds an die Oberfläche des Targets (8),
**dadurch gekennzeichnet**,
daß das Target (8) In oder In und Sn enthält,
daß das Zerstäubungsgas zumindest Sauerstoff enthält
und daß die Intensität des Magnetfelds bei der Ausbildung der leitfähigen Schicht während des Zerstäubungsprozesses so verstärkt wird, daß eine zeitlich konstante Zerstäubungsspannung von 340 Volt oder weniger beibehalten wird.

## Revendications

1. Procédé pour fabriquer un film conducteur transparent à base de Ino ou de InSnO sur un substrat (4), consistant à :
exécuter une pulvérisation cathodique sur une cible (8) en appliquant une tension de pulvérisation à la cible tout en introduisant un gaz de pulvérisation afin de générer une décharge plasma entre le substrat (4) et la cible (8) ;
appliquer un champ magnétique à la surface de la cible (8),
caractérisé en ce que :
la cible (8) est composée de In, ou de In et Sn ;
le gaz de pulvérisation est composé au moins d'oxygène ; et,
l'intensité du champ magnétique est augmenté quand le film conducteur est en cours de formation pendant l'opération de pulvérisation cathodique, de telle manière qu'on maintient constante la tension de pulvérisation en fonction du temps à 340 volts ou moins.
